(19) **Europäisches Patentamt**
**European Patent Office**
**Office européen des brevets**

(11) **EP 4 753 413 A1**

(12) **EUROPEAN PATENT APPLICATION**
published in accordance with Art. 153(4) EPC

(43) Date of publication:
**03.06.2026 Bulletin 2026/23**

(21) Application number: **24846050.3**

(22) Date of filing: **24.07.2024**

(51) International Patent Classification (IPC):
*H10H 20/82* (2025.01)    *H10H 20/855* (2025.01)
*H10H 20/85* (2025.01)    *H10H 20/852* (2025.01)
*H01L 25/075* (2006.01)   *H10H 20/812* (2025.01)

(52) Cooperative Patent Classification (CPC):
**H10W 90/00; H10H 20/812; H10H 20/82;
H10H 20/821**

(86) International application number:
**PCT/KR2024/010764**

(87) International publication number:
**WO 2025/023748 (30.01.2025 Gazette 2025/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.07.2023  US 202363528702 P
21.09.2023  US 202363539694 P
28.03.2024  US 202463571015 P
22.07.2024  US 202418780241**

(71) Applicant: **Seoul Viosys Co., Ltd.
Ansan-si, Gyeonggi-do 15429 (KR)**

(72) Inventor: **BAEK, Yong Hyun
Ansan-Si Gyeonggi-do 15429 (KR)**

(74) Representative: **Stolmár & Partner
Patentanwälte PartG mbB
Blumenstraße 17
80331 München (DE)**

(54) **LIGHT-EMITTING ELEMENT AND LIGHT-EMITTING DEVICE COMPRISING SAME**

(57)    A light emitting device and a light emitting apparatus including the same are disclosed. A light emitting device includes a substrate, a plurality of protrusions protruding from one surface of the substrate, and a light emitting structure disposed on the substrate.

【FIG. 1】

**Description**

[Technical Field]

Embodiments of the disclosed technology relate to a light emitting device and a light emitting apparatus including the same.

[Background Art]

Light emitting diodes (LEDs) are widely used as a self-emissive light source. Light emitting diodes utilize properties of compound semiconductors to convert electrical signals into light, such as infrared, visible, and ultraviolet light.
With improvement in luminous efficacy, light emitting diodes are applied to various fields including displays and lighting devices and the size of the light emitting diodes is also getting smaller to allow the use of mini-LEDs and micro-LEDs.
In recent years, nitride semiconductors have been widely used as a base material for light emitting devices, such as light emitting diodes. Since nitride semiconductors can have various energy bandgaps depending on a composition ratio of Group III elements, it is possible to realize light in various wavelength bands by controlling the composition ratio of elements, such as Al, Ga, and In.
A multi-quantum well structure (MQW) may be used as the structure of an active layer and an emission wavelength of the light emitting device may be determined by the composition ratio of nitride semiconductors in a well layer of the multi-quantum well structure.
Typically, light emitting diodes can be used in the form of a light emitting diode package, in which light emitting diode chips are mounted on a substrate, such as a printed circuit board (PCB), which includes an interconnection layer and an insulation layer.
A red (R) light emitting diode chip, a green (G) light emitting diode chip, and a blue (B) light emitting diode chip may be mounted on a single substrate such that light emitted from each of the light emitting diode chips is mixed with light emitted from the other light emitting diode chips to emit white light, and a display apparatus may be realized by constituting a single pixel using the red (R), green (G), and blue (B) light emitting diode chips.
Light is composed of a mixture of three primary colors of red, green, and blue, and various colors can be realized by combining the three primary colors of RGB.
The CIE L*a*b color space is a color space generated through non-linear transformation of the CIE XYZ color space based on the antagonistic theory of human vision. The CIE L*a*b color space is defined based on research on human vision and luminance L is designed corresponding to brightness perceived by humans. A luminance L of 0 represents black and a luminance L of 100 represents white. In a display system, luminance L can be constructed by taking RGB signals in a ratio of 3:6:1. Technological development is required to ensure that clearer colors can be accurately displayed in display apparatuses adopting combinations of red (R), green (G), and blue (B) light.

[Disclosure]

[Technical Problem]

Embodiments of the disclosed technology provide a light emitting device allowing easy growth of semiconductor layers and having improved light extraction efficiency, and a light emitting apparatus including the same.
Embodiments of the disclosed technology provide a light emitting device capable of improving color clarity and a light emitting apparatus including the same.

[Technical Solution]

In accordance with one aspect of the embodiment, a light emitting device (100) includes: a substrate (110); a plurality of protrusions (P) protruding from one surface of the substrate (110); and a light emitting structure (120) disposed on the substrate (110).
In one embodiment, when a pitch between adjacent protrusions P is denoted by D1 and a short-side length of the light emitting device 100 in a plane is denoted by A, the light emitting device (100) may satisfy an equation: $A = \alpha \times D1$, where $\alpha$ is greater than or equal to 5.
In accordance with another aspect of the embodiment, a light emitting apparatus (1000) includes: a light emitting device (100) including a substrate (110), a plurality of protrusions (P) protruding from one surface of the substrate (110), and a light emitting structure (120) disposed on the substrate (110); and a circuit board (1010) on which the light emitting device (100) is mounted.

In one embodiment, the light emitting apparatus (1000) may further include a light transmitting member (800) covering the light emitting device (100), wherein, when a maximum width of the protrusions (P) is denoted by D2, a vertical height from one surface of the substrate (110) to an apex (Q) of the protrusions (P) is denoted by D3, a maximum width of the light transmitting member (800) in a horizontal direction is denoted by S1, and a vertical height from an upper surface of the circuit board (1010) to an apex (N) of the light transmitting member (800) is denoted by S2, the light emitting apparatus (1000) may satisfy a relation: $\frac{D2}{D3} < \frac{S1}{S2}$.

In one embodiment, the light emitting apparatus (1000) may further include a molding layer (900) covering the light emitting device (100), wherein, when a vertical height from one surface of the substrate (110) to an apex (Q) of the protrusions (P) is denoted by D3 and a vertical height from an upper surface of the light emitting device (100) to an upper surface of the molding layer (900) is denoted by L, L may be greater than or equal to 50 times D3.

In accordance with a further aspect of the embodiment, a light emitting apparatus (1000) includes: a substrate (110), a first light emitting device (200) disposed on one surface of the substrate (110) and generating light having a first peak wavelength, a second light emitting device (300) disposed on one surface of the substrate (110) and generating light having a second peak wavelength different from the first peak wavelength, and a third light emitting device (400) disposed on one surface of the substrate (110) and generating light having a third peak wavelength different from the first and second peak wavelengths.

In one embodiment, each of the first to third light emitting devices (200; 300; 400) may include a first conductivity type semiconductor layer (222; 322; 422), an active layer (224; 324; 424) having a multi-quantum well structure, and a second conductivity type semiconductor layer (226; 326; 426).

In one embodiment, the number of pairs of barrier layers and well layers constituting the active layer (224) of the first light emitting device (200) may be different from the number of pairs of barrier layers and well layers constituting the active layer (324) of the second light emitting device (300).

[Effects of the Invention]

Embodiments may provide a light emitting module capable of improving color clarity and a display apparatus including the same.

[Description of Drawings]

FIG. 1 is a cross-sectional view of a light emitting device according to one embodiment.

FIG. 2 is a partially enlarged view of the light emitting device shown in FIG. 1.

FIG. 3 is a plan view of the light emitting device of FIG. 1.

FIG. 4 and FIG. 5 show modifications of the light emitting device shown in FIG. 2.

FIG. 6 is a view illustrating examples of a light emitting apparatus including the light emitting device according to the embodiment.

FIG. 7A and FIG. 7B are cross-sectional views of a light emitting apparatus according to one embodiment.

FIG. 8 is a cross-sectional view of a light emitting apparatus according to another embodiment.

FIG. 9 shows a modification of the light emitting apparatus shown in FIG. 8.

FIG. 10 is a perspective view of a light emitting apparatus according to another embodiment.

FIG. 11 is a view of a light emitting device constituting the light emitting apparatus of FIG. 10.

FIG. 12 is a side view illustrating three light emitting devices constituting a single pixel in the light emitting apparatus of FIG. 10.

FIG. 13 is a view of a modification of the light emitting device shown in FIG. 12.

FIG. 14 is an enlarged cross-sectional view of a first light emitting device generating light having a first peak wavelength.

FIG. 15 is an enlarged view of region E in FIG. 14.

FIG. 16 is an enlarged view of region F in FIG. 15.

FIG. 17 is an enlarged view of region G in FIG. 15.

FIG. 18 is an enlarged cross-sectional view of a second light emitting device generating light having a second peak wavelength.

FIG. 19 is an enlarged view of region E' in FIG. 18.

FIG. 20 is an enlarged view of region F' in FIG. 19.

FIG. 21 is an enlarged view of region G' in FIG. 19.

FIG. 22 is a cross-sectional view showing a V-fit formed in a light emitting device.

[Detailed Description]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

The embodiment provides a light emitting device 100 including a light emitting structure 120 and a light emitting apparatus 1000 including the light emitting device 100. Hereinafter, exemplary embodiments will be described in more detail with reference to the accompanying drawings.

The light emitting device 100 is a light emitting diode chip generating light and may include a substrate 110 and a light emitting structure 120 disposed on the substrate 110.

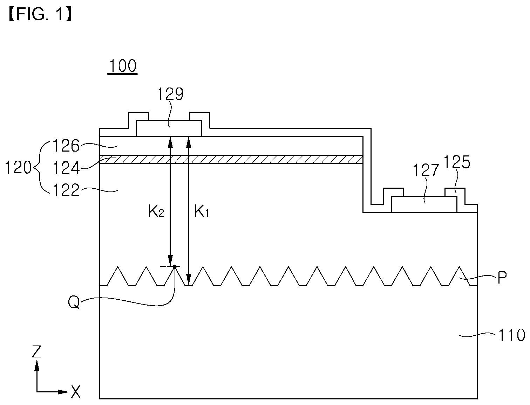

FIG. 1 shows a light emitting device 100 according to one embodiment.

Specifically, the light emitting device 100 may include a substrate 110 and a light emitting structure 120 disposed on the substrate 110.

The substrate 110 is a substrate on which semiconductor layers described below are disposed and may be selected from any substrates that allow growth of nitride semiconductors thereon.

EP 4 753 413 A1

For example, the substrate 110 may include a heterogeneous substrate, such as a sapphire substrate, a gallium arsenide substrate, a silicon substrate, a silicon carbide substrate, or a spinel substrate, and may also include a homogeneous substrate, such as a gallium nitride substrate, an aluminum nitride substrate, or others. The substrate 110 may be a growth substrate on which semiconductor layers can be grown.

The light emitting structure 120 includes semiconductor layers disposed on the substrate 110, which may include a first conductivity type semiconductor layer 122, an active layer 124, and a second conductivity type semiconductor layer 126.

The first conductivity type semiconductor layer 122 may be a semiconductor layer disposed on one surface of the substrate 110 and a buffer layer (not shown) may be further interposed between the first conductivity type semiconductor layer 122 and the substrate 110. The buffer layer may include a nitride or phosphide semiconductor, such as GaN, GaAs, or others, and may be grown by metal organic chemical vapor deposition (MOCVD).

The buffer layer can improve crystallinity of the semiconductor layers disposed on the substrate 110 in a subsequent process and can also serve as a seed layer for growth of nitride semiconductor layers on a heterogeneous substrate.

The first conductivity type semiconductor layer 122 may include a phosphide or nitride semiconductor, such as (Al, Ga, In)P or (Al, Ga, In)N, and may be grown on the substrate 110 through a technique, such as MOCVD, MBE, HVPE, or others. In addition, the first conductivity type semiconductor layer 122 may be doped with at least one type of n-type dopant, such as Si, C, Ge, Sn, Te, Pb, or others. However, it should be understood that the embodiment is not limited thereto. Alternatively, the first conductivity type semiconductor layer 122 may also be doped with a p-type dopant to become an opposite conductivity type.

In addition, the first conductivity type semiconductor layer 122 may be composed of a single layer or multiple layers. For example, the first conductivity type semiconductor layer 122 may include a first sub-conductivity type semiconductor layer and a second sub-conductivity type semiconductor layer disposed on the first sub-conductivity type semiconductor layer.

The first sub-conductivity type semiconductor layer and the second sub-conductivity type semiconductor layer may be doped at different concentrations and may be formed at different process temperatures. When the first conductivity type semiconductor layer 122 is composed of multiple layers, the first conductivity type semiconductor layer 122 may include a superlattice layer.

Furthermore, the first conductivity type semiconductor layer 122 may further include a contact layer, a modulation doping layer, an electron implantation layer, and the like.

The active layer 124 is a light emitting layer formed on the first conductivity type semiconductor layer 122, may include a phosphide or nitride semiconductor, such as (Al, Ga, In)P or (Al, Ga, In)N, and may be grown on the first conductivity type semiconductor layer 122 through a technique, such as MOCVD, MBE, or HVPE.

The active layer 124 may include a quantum well structure (QW) including at least two barrier layers and at least one well layer. Alternatively, the active layer 124 may include a multi-quantum well structure (MQW) including a plurality of barrier layers and a plurality of well layers.

The wavelength of light emitted from the active layer 124 may be adjusted by controlling a composition ratio of materials constituting the well layer. Here, the well layers may have the same element in common and may include indium (In).

The well layer is disposed between the barrier layers and the bandgap energy of the well layer is smaller than the bandgap energy of the barrier layer.

The well layer may include or be formed of $In_xGa_{(1-x)}N$ or $In_xGa_{(1-x)}P$ (0 < x < 1), in which the wavelength of light emitted from the active layer may be adjusted according to the composition ratio (x) of In.

The barrier layers and the well layers are alternately stacked one above another, preferably alternately stacked at least twice. A barrier layer and a well layer adjacent thereto may constitute a pair.

The second conductivity type semiconductor layer 126 may be a semiconductor layer formed on the active layer 124.

The second conductivity type semiconductor layer 126 may include a phosphide or nitride semiconductor, such as (Al, Ga, In)P or (Al, Ga, In)N, and may be grown through a technique, such as MOCVD, MBE, or HVPE. The second conductivity type semiconductor layer 126 may be doped to become a conductivity type opposite to the conductivity type of the first conductivity type semiconductor layer 122. For example, the second conductivity type semiconductor layer 126 may be doped with p-type dopants, such as Mg.

The second conductivity type semiconductor layer 126 may have a monolayer structure having a composition, such as, p-GaN, and may further include an AlGaN layer therein, without being limited thereto.

The light emitting device may further include an electron blocking layer having a relatively large energy bandgap between the second conductivity type semiconductor layer 126 and the active layer 124. The electron blocking layer may be placed on the active layer 124 to prevent electrons from overflowing from the active layer 124 to another layer above the active layer 124, that is, to the second conductivity type semiconductor layer 126.

6

The electron blocking layer may be formed on the uppermost barrier layer of the active layer 124. The electron blocking layer may have a greater average energy bandgap than the uppermost barrier layer, whereby migration of electrons to the second conductivity type semiconductor layer 126 can be blocked by an energy barrier of the electron blocking layer.

Further, the light emitting device 100 may include an insulation layer 125 covering the first conductivity type semiconductor layer 122 and the second conductivity type semiconductor layer 126 and defining openings in which the N, P electrode pads 127, 129 are disposed.

The two electrode pads 127, 129 may be electrically connected to the first conductivity type semiconductor layer 122 and the second conductivity type semiconductor layer 126, respectively, through the openings in the insulation layer 125. However, it should be understood that the structure of the light emitting device 100 according to this embodiment is not limited thereto and the N, P electrode pads 127, 129 may be directly soldered to the circuit board without connection electrodes.

In one example, the light emitting device 100 may be a blue light emitting diode that emits blue light B and has a peak wavelength within the blue wavelength band, in which a difference between a peak wavelength and a dominant wavelength of the blue light emitting diode may be in the range of 2 nm to 15 nm. Specifically, the blue light emitting diode may have a peak wavelength of 430 nm to 475 nm and a dominant wavelength of 460 nm to 480 nm. The peak wavelength of the blue light emitting diode may be shorter than the dominant wavelength thereof.

In another example, the light emitting device 100 may be a green light emitting diode that emits green light G and has a peak wavelength within the green wavelength band, in which a difference between the peak wavelength and a dominant wavelength of the green light emitting diode may be in the range of 5 nm to 20 nm. Specifically, the green light emitting diode may have a peak wavelength of 510 nm to 540 nm and a dominant wavelength of 525 nm and 545 nm. The peak wavelength of the green light emitting diode may be shorter than the dominant wavelength thereof.

In another example, the light emitting device 100 may be a red light emitting diode that emits red light R and has a peak wavelength within the red wavelength band, in which a difference between the peak wavelength and a dominant wavelength of the red light emitting diode may be in the range of 5 nm to 30 nm. Specifically, the red light emitting diode may have a peak wavelength of 620 nm to 640 nm and a dominant wavelength of 600 nm to 630 nm. The peak wavelength of the red light emitting diode may be longer than the dominant wavelength thereof.

It will be apparent that the light emitting device 100 may be realized in various ways and may be modified into various structures including a flip-chip structure, a vertical structure, a horizontal structure, and the like

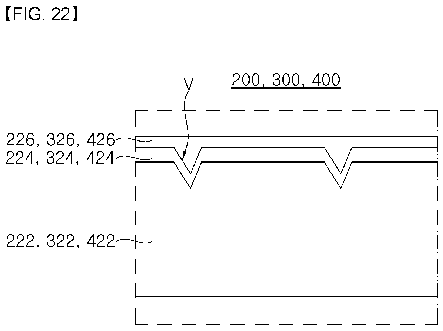

Referring to FIG. 22, the light emitting device 100 may also have a V-pit formed in a growth process of each layer.

The plurality of light emitting devices 100 emitting blue light, green light, and red light, respectively, may be horizontally arranged in one direction to form a single pixel (PX).

Alternatively, the light emitting device 100 may be a stack type light emitting diode including a plurality of light emitting structures 120 stacked one above another. The stack type light emitting diode may include a first light emitting structure, a second light emitting structure, and a third light emitting structure stacked sequentially. The second light emitting structure may be disposed on the first light emitting structure and the third light emitting structure may be stacked on the second light emitting structure. Each of the first to third light emitting structures may include the first conductivity type semiconductor layer, the active layer, and the second conductivity type semiconductor layer described above.

The first to third light emitting structures may be a light emitting structure that emit red light, a light emitting structure that emits green light, and a light emitting structure that emits blue light, respectively. Thus, the stack type light emitting device 100 including the first to third light emitting structures may constitute one pixel (PX) that displays three primary colors of RGB.

On the other hand, the light emitting device 100 may have a long side and a short side in a plane. When the short-side length of the light emitting device 100 is denoted by A and the long-side length thereof is denoted by B, A may have a value in the range of 5 $\mu$m to 400 $\mu$m and B may have a value in the range of 400 $\mu$m to 650 $\mu$m.

In addition, the light emitting device 100 may include a plurality of protrusions P protruding from one surface of the substrate 110. The plurality of protrusions P may be formed by patterning one surface of the substrate 110.

That is, the plurality of protrusions P may be formed in a protrusion pattern protruding from one surface of the substrate 110 in an upward direction.

A peak-to-peak pitch between adjacent protrusions P may be defined as D1, a maximum width of the protrusion P may be defined as D2, a vertical height from one surface of the substrate 110 to an apex Q of the protrusion P may be defined as D3, and a separation distance between adjacent protrusions P may be defined as D4.

D1 may have a value in the range of 1.7 $\mu$m to 2.2 $\mu$m.

D2 may have a value in the range of 1.5 $\mu$m to 2 $\mu$m. Here, D1 may have a greater value than D2. For example, D1 may have a value in the range of 1 to 1.5 times D2. Preferably, D1 has a value in the range of 1 to 1.2 times D2.

D3 may have a value in the range of 0.8 $\mu$m to 1.2 $\mu$m. D3 may have a smaller value than D1. For example, D1 may have a value in the range of 1 to 3 times D3. Preferably, D1 has a value in the range of 1.6 to 2.2 times D3. Further, D2 may have a value in the range of 1 to 3 times D3. Preferably, D2 has a value in the range of 1.5 to 2.5 times D3.

D4 may have a value in the range of 0 μm to 0.7 μm, preferably 0.1 μm to 0.3 μm.

The plurality of protrusions P may have slightly different shapes from each other and D1 to D4 may also have different values.

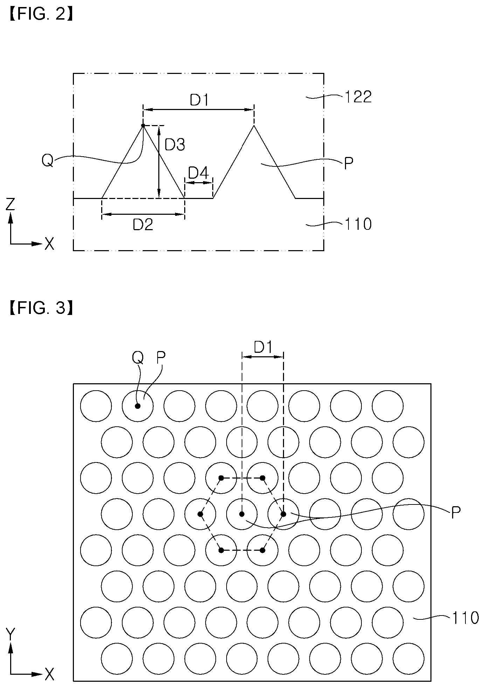

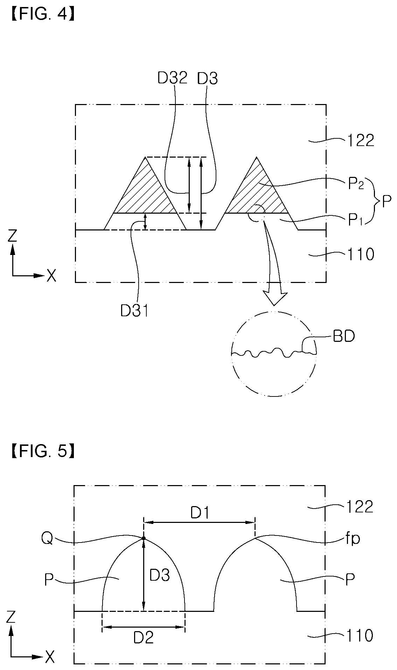

In FIG. 1 and FIG. 2, the protrusions P are shown in the form of a conical or polygonal shape that gradually decreases in horizontal width in an upward direction. Alternatively, the protrusions may be formed in any shapes so long as the protrusions protrude from one surface of the substrate 110. For example, referring to FIG. 5, the protrusions P may be formed in a bell shape with convex sides. The protrusions P may be formed in a generally triangular shape when viewed in a cross-section perpendicular to the substrate 110, without being limited thereto.

The short-side length A of the light emitting device 100 in plan view may satisfy Equation 1:

$$A = \alpha \times D1, \qquad\qquad \text{---Equation (1)}$$

where α is greater than or equal to 5.

For example, when D1 is 1.9 μm, the light emitting device 100 may have a short-side length A of 9.5 μm or more. Further, α may be greater than or equal to 5 and less than or equal to 140. Here, α may be a real number.

Alternatively, the short-side length A of the light emitting device 100 in plan view may satisfy Equation (2):

$$A = \beta \times D2, \qquad\qquad \text{---Equation (2)}$$

where β is greater than or equal to α.

For example, when D2 is 1.7 μm, the light emitting device 100 may have a short-side length A of 8.5 μm or more. Further, β may be greater than or equal to 5 and less than or equal to 155. Here, β may be a real number.

Alternatively, the short-side length A of the light emitting device 100 in plan view may satisfy Equation (3):

$$A = \gamma \times D3, \qquad\qquad \text{---Equation (3)}$$

where γ is greater than or equal to 2α.

For example, when D3 is 1 μm, the light emitting device 100 may have a short-side length A of 10 μm or more. Further, γ may be greater than or equal to 10 and less than or equal to 230. Here, γ may be a real number.

Accordingly, the length of the light emitting device 100 can be designed in consideration of the diameter of the protrusions P to maintain an optimal ratio between the protrusions P and the light emitting device 100.

Referring again to FIG. 1, a height K2 from the apex Q of the protrusions P to an upper surface of the light emitting structure 120 may have a value in the range of 0.7 to 0.9 times a height K1 from one surface of the substrate 110 to the upper surface of the light emitting structure 120. Here, the upper surface of the light emitting structure 120 may be a light emitting surface or one surface of the second conductivity type semiconductor layer 126. Accordingly, the height or thickness of the light emitting structure 120 may be designed in consideration of the height of the protrusions P to maintain an optimal ratio between the protrusions P and the light emitting structure 120.

Next, referring to FIG. 3, the plurality of protrusions P may be distributed in various patterns in a plane on one surface of the substrate 110.

For example, the plurality of protrusions P may be arranged in a square grid pattern or distributed in a hexagonal grid pattern, as shown in FIG. 3. A diameter of each of the protrusions P and a distance between the protrusions P may be within a certain range of tolerance.

A total area occupied by the protrusions P may be in the range of 60% to 90% of a total area of one surface of the substrate 110.

The protrusions P may be formed at a density of 200,000 or more per mm$^2$. The protrusions P may be formed at a density of 200,000 to 280,000 per mm$^2$.

FIG. 3 shows an example in which the protrusions P are arranged in a regular pattern, without being limited thereto.

Although FIG. 1 and FIG. 2 show an example wherein the protrusions P1 are integrally formed with the substrate 110, it should be understood that each of the protrusions P may include a first protrusion P1 integrally formed with the substrate 110 and a second protrusion P2 disposed on the first protrusion P1, as shown in FIG. 4.

The first protrusion P1 is a layer integrally formed with the substrate 110 and may be formed of the same material as the substrate 110. An upper surface of the first protrusion P1 may have a circular shape.

The second protrusion P2 may be formed of a different material than the first protrusion P1. The second protrusion P2 may have a different index of refraction than the first protrusion P1. A boundary BD between the first protrusion P1 and the second protrusion P2 may be flat or may include a plurality of irregularities protruding from the surface thereof.

A vertical height D32 of the second protrusion P2 may be greater than a vertical height D31 of the first protrusion P1. In addition, side surfaces of the first protrusion P1 and the second protrusion P2 at the boundary BD therebetween may have a variable inclination. With different inclinations of the first protrusion P1 and the second protrusion P2, the light emitting device can have an increased degree of scattering light emitted therefrom and can have improved light emission efficiency.

A light emitting apparatus 1000 according to the embodiment may include at least one light emitting device 100. The light emitting apparatus 1000 may be a light emitting module, a display module, or a display apparatus. The light emitting module may be a light emitting diode package including at least one light emitting device 100. The display module may be provided in plural to constitute a single display apparatus.

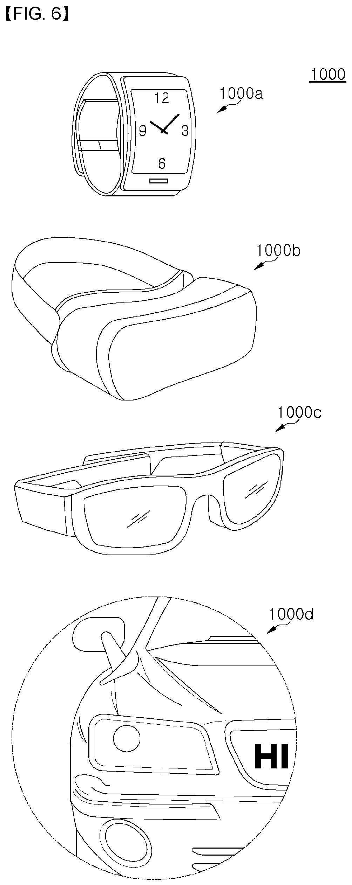

For example, the light emitting apparatus 1000 may be applied to a display panel, which may be applied to signage, a display, or a vehicle. Specifically, the light emitting apparatus 1000 may be applied to various apparatuses, such as a smartwatch 1000a, a VR headset 1000b, an AR device such as augmented reality glasses 1000c, signage, or others, as shown in FIG. 6. Specifically, the light emitting apparatus 1000 may be applied to a display of a vehicle 1000d to implement icons, such as character strings (English, numbers, Korean, or others) or pictures. To implement characters or icons, the light emitting apparatus 1000 may be networked with an external source, which may be an application program, a vehicle on-board system setting, or the like.

Furthermore, the light emitting apparatus 1000 may be a display module and may be provided in plural such that a display screen of various sizes can be realized by disposing side surfaces of the plurality of display modules to contact each other.

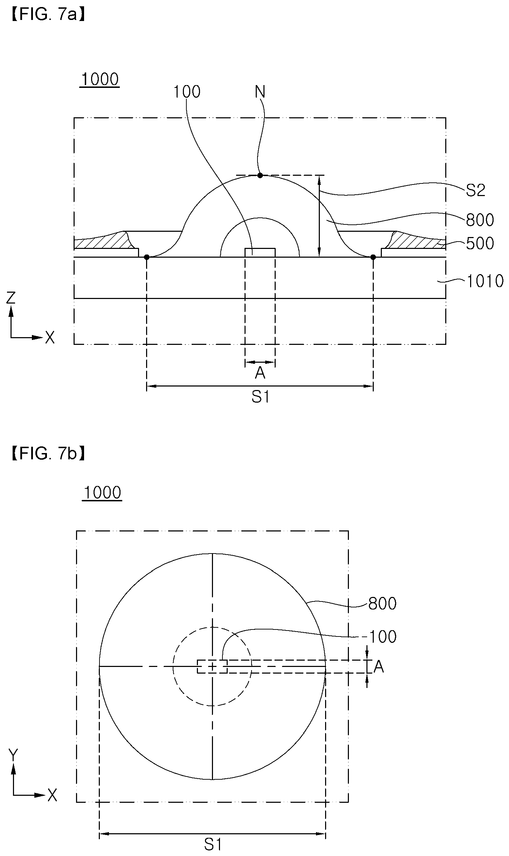

FIG. 7A and FIG. 7B illustrate an example of the light emitting apparatus 1000 including the light emitting device 100 according to the embodiment. The light emitting apparatus 1000 may be a light emitting diode package including the light emitting device 100.

The light emitting apparatus 1000 may include a light emitting device 100, a circuit board 1010 on which the light emitting device 100 is mounted, and a light transmitting member 800 disposed on the light emitting device 100.

The light emitting device 100 may have the same or similar configuration to the light emitting device described with reference to FIG. 1 to FIG. 5 and thus detailed description thereof will be omitted.

The circuit board 1010 is a substrate on which the light emitting device 100 is mounted and may be configured in various ways. The circuit board 1010 is a substrate including an upper surface on which at least one light emitting device 100 is mounted, and may be selected from any substrate, such as a circuit board or lead frame, a flexible substrate, a transparent substrate, or others, as long as the substrate is capable of supporting the light emitting device 100.

For example, the circuit board 1010 may include a printed circuit board (PCB). The PCB may be, for example, an FR4 PCB, which has excellent properties, such as high strength, flame retardancy, chemical resistance, and the like. Alternatively, the circuit board 1010 may be a Metal PCB (Metal Printed Circuit Board), which ensures excellent heat dissipation performance and good thermal conductivity. More specifically, the circuit board 1010 may be a PCB including Cu, Zn, Au, Ni, Al, Mg, Cd, Be, W, Mo, Si, or Fe as a base metal, or an alloy of at least one of these metals. However, it should be understood that the embodiment is not limited thereto and various PCBs may be used depending on characteristics of products.

The circuit board 1010 may include an insulation layer and interconnections for electrical connection with the light emitting device 100, and may include circuits for supplying an electrical source, such as current or voltage, to the light emitting device 100 to drive the light emitting device 100.

The circuit board 1010 may be formed on an upper surface thereof with a pad for mounting at least one light emitting device 100 thereon and on a lower surface thereof with a pad to be mounted on another substrate (not shown, for example, a display substrate).

The circuit board 1010 may have a monolayer structure or multilayer structure and may be formed to various thicknesses, as needed.

The light transmitting member 800 may transmit light emitted from the light emitting device 100 and may adjust beam angle by changing an optical path of light emitted from the light emitting device 100.

A reflective film 500 may be placed on the upper surface of the circuit board 1010 and an opening may be formed in the reflective film 500 to expose a region in which the light emitting device 100 is mounted. The light emitting device 100 mounted within the opening may be covered by the light transmitting member 800.

The reflective film 500 may include a convex portion projecting upwards along a periphery of the opening. At the convex portion, the reflective film 500 may be placed at a height above the upper surface of the light emitting device 100. Light emitted from the light emitting device 100 may pass through the light transmitting member 800 and be reflected on a side surface of the convex portion of the reflective film 500, thereby improving light extraction efficiency.

The light transmitting member 800 may include an inner recess in which the light emitting device 100 is placed and a convex surface through which light is emitted.

The light transmitting member 800 is formed in a bell shape in which a light exit surface of the light transmitting member 800 has a convex shape at an apex N thereof. Here, the light transmitting member 800 may have inflection points fl at which a side surface of the light transmitting member 800 is changed to a concave shape in a region adjoining the circuit board 1010. Accordingly, the number of inflection points fl on the light exit surface of the light transmitting member 800 may be greater than the number of inflection points fp on the protrusion P.

In addition, when a maximum width of the light transmitting member 800 in a horizontal direction is denoted by S1 and the vertical height from the upper surface of the circuit board 1010 to the apex N of the light transmitting member 800 is denoted by S2, the light emitting apparatus satisfies a relation of Equation 4:

$$\frac{D2}{D3} < \frac{S1}{S2}. \qquad \text{--- Equation(4)}$$

In other words, the width S1 of the light transmitting member 800 relative to the height S2 thereof may be greater than the width D2 of the protrusion P relative to the height D3 thereof. $\frac{S1}{S2}$ may be in the range of 1.5 to 3 times $\frac{D2}{D3}$.

Furthermore, the height S2 of the light transmitting member 800 may have a value in the range of 800 to 1,200 times the height D3 of the protrusions P.

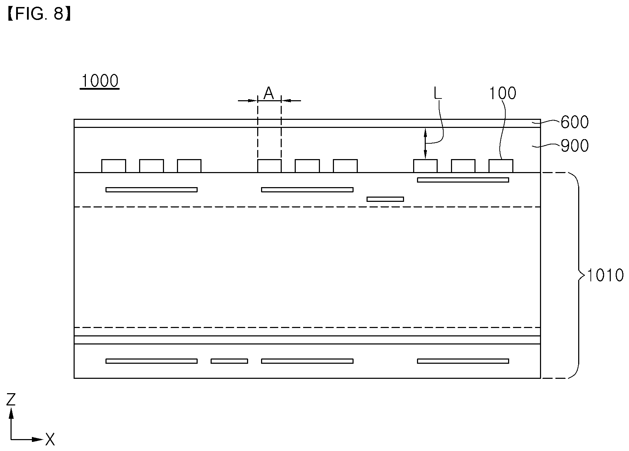

FIG. 8 is a cross-sectional view of another example of the light emitting apparatus 1000 including the light emitting device 100 according to the embodiment. The light emitting apparatus 1000 may be a display module or a display apparatus.

The light emitting apparatus 1000 may include at least one light emitting device 100, a circuit board 1010 on which the light emitting device 100 is mounted, and a molding layer 900 covering the light emitting device 100.

The light emitting device 100 may have the same or similar configuration to the light emitting device described with reference to FIG. 1 to FIG. 5 and thus detailed description thereof will be omitted. The circuit board 1010 may have the same or similar configuration to that described with reference to FIG. 7A and FIG. 7B and detailed description thereof will be omitted.

A plurality of light emitting devices 100 may be arranged in various patterns on the upper surface of the circuit board 1010. For example, three light emitting devices 100 emitting red (R), green (G), and blue (B) light, respectively, may be arranged in a line in one direction to form a single pixel (PX). Alternatively, R, G and B light emitting diodes may be vertically stacked in one light emitting device 100 to form a single pixel (PX).

It should be understood that the embodiment is not limited to three light emitting devices 100 arranged in a line to constitute a single pixel (PX) and the light emitting devices 100 may be arranged out of alignment in a plane.

The molding layer 900 covers the light emitting devices 100 and may have various configurations. The molding layer 900 may cover both upper and side surfaces of the light emitting devices 100. The molding layer 900 may encapsulate the plurality of light emitting devices 100 and may act as a refractive layer that refracts light emitted therefrom. The molding layer 900 may be composed of a single layer or multiple layers and may be a transparent, light-transmitting molding for transmitting light emitted from the light emitting devices 100.

The molding layer 900 may be formed of a resin including, for example, at least one of acrylate, silicone, epoxy, PMMA (polymethyl methacrylate), and PS (polystyrene) resins, without being limited thereto. The molding layer 900 may also be formed of a fluoropolymer to improve efficiency in light extraction from the light emitting devices 100.

For example, the molding layer 900 may be formed by applying a sheet-type molding agent, liquefying the molding agent through heat treatment at high temperature, and pressing the molding agent toward the light emitting devices 100. Alternatively, the molding layer 900 may be formed by curing the resin through UV treatment.

The thermosetting resin may include polymers that do not undergo crosslinking reaction by heat, and can become fluid or soft through increase in kinetic energy of the polymers when heat is applied thereto. Thus, a mold may be formed to fill a space around the light emitting devices 100 by pressing the molding agent toward the light emitting devices 100 at high temperature after applying the molding agent to the light emitting devices 100.

Alternatively, the molding layer 900 may be a light-transmissive layer formed of a light transmissive material. The molding layer 900 may have a light transmittance of 50% or more, preferably 70% or more. Here, the molding layer 900 may have a light blocking rate of 40% or less.

In another example, the molding layer 900 may further include a light reflective material or a light absorbing material. Here, the molding layer 900 may be an opaque layer and may include a black pigment to adjust display contrast. The molding layer 900 may also include a matrix containing a light scattering material, such as silica.

In another example, the molding layer 900 may perform both a light blocking function and a light reflecting function. For example, the molding layer 900 may be formed of a carbon black molding agent or a molding agent that combines black and white.

In another example, the molding layer 900 may further have a light absorbing function in addition to the light reflecting function. For example, the molding layer 900 may be formed of a white molding agent or a molding agent that combines white and black. Accordingly, the molding layer 900 can adjust contrast of light emitted therethrough while improving brightness of the display apparatus.

In another example, the molding layer 900 may further include a light diffusing material capable of diffusing light emitted from the plurality of light emitting devices 100. By way of example, the light diffusing material may include at least one of $TiO_2$, $BaO$, $SiO_2$, $MgO$, or $Y_2O_3$ capable of scattering light, which may be distributed within the molding layer 900.

The molding layer 900 may have various thicknesses.

Although FIG. 8 shows an example in which the molding layer 900 is composed of a single layer, it should be understood that the embodiments are not limited thereto and a plurality of molding layers 910, 920 may be stacked, as shown in FIG. 8, in which each layer may perform a light control function, such as light reflection, light absorption, light blocking, light diffusion, or others.

In the structure where the molding layer 900 includes the plurality of molding layers 910, 920, the molding layer 900 may include a first molding layer 910 disposed between the light emitting devices 100 and covering side surfaces of the light emitting devices 100, and a second molding layer 920 disposed on the first molding layer 910 and covering an upper surface of the light emitting devices 100.

Between adjacent light emitting devices 100, an upper surface of the first molding layer 910 may form a concave surface.

The light emitting apparatus 1000 may further include a film layer 600 disposed on the molding layer 900. At least one of the refractive index, melting point, and light transmittance of the film layer 600 may be different from the refractive index, melting point, and light transmittance of the molding layer 900.

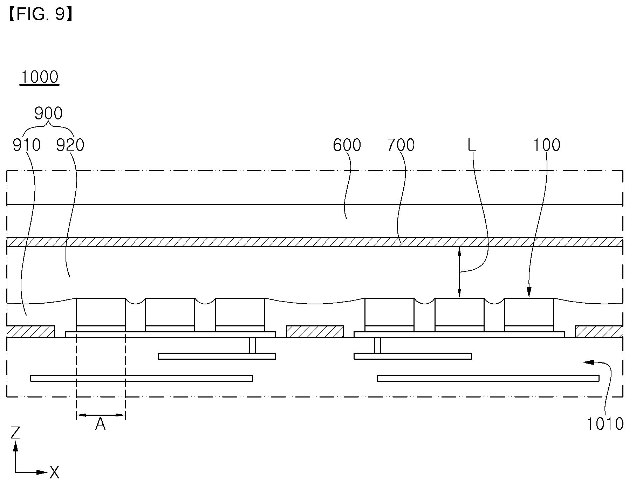

The film layer 600 is a layer that controls light emitted onto the molding layer 900 and may have various configurations. As shown in FIG. 9, the light emitting apparatus 1000 may further include a bonding layer 700 between the molding layer 900 and the film layer 600 to attach the film layer 600. For example, the film layer 600 may be an anti-glare layer capable of preventing glare.

The film layer 600 may be formed through matt treatment. For example, the film layer 600 may be a matt film layer subjected to matt treatment and attached to the upper surface of the molding layer 900.

Alternatively, the film layer 600 may be formed, for example, by attaching an anti-glare (AG) film or by coating with an anti-glare (AG) coating.

The film layer 600 may be formed to a much thinner thickness than the molding layer 900. However, it should be understood that the embodiment is not limited thereto. That is, the film layer attached to the upper surface of the molding layer 900 may have a variety of thicknesses and films with various thicknesses may be selectively attached to the molding layer 900.

The light emitting apparatus 1000 shown in FIG. 8 and FIG. 9 may be provided in plural to be disposed adjacent to each other so as to form a display panel with various sizes.

On the other hand, when a vertical height from one surface of the substrate 110 to the apex Q of the protrusions P is denoted by D3 and a vertical height from an upper surface of the light emitting device 100 to the upper surface of the molding layer 900 is denoted by L, L may be greater than or equal to 50 times D3.

Furthermore, when a pitch between adjacent protrusions P is denoted by D1 and the maximum width of the protrusions P is denoted by D2, L may satisfy a relation of Equation (5):

$$\frac{L}{2} > D1 + D2 + D3. \qquad\qquad \text{---Equation (5)}$$

By limiting the numerical ranges of the dimensions (long-side length, short-side length, height) of the light emitting devices 100, the dimensions (width, height) of the light transmitting member 800, and the thickness of the molding layer 900 depending upon the separation distance D1, width D2, and height H3 of the protrusions P disposed on one surface of the substrate 110, the light emitting apparatus according to the embodiment can achieve improvement in light extraction efficiency by the protrusions P while enabling efficient growth of the semiconductor layers on the substrate 110.

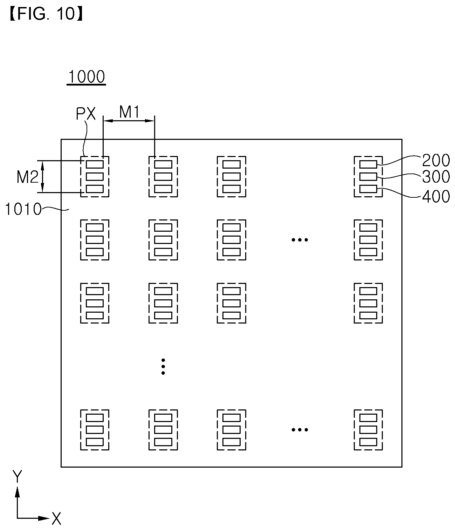

FIG. 10 shows another example of the light emitting apparatus 1000 including the light emitting device 100 according to the embodiment and is a plan view of the light emitting apparatus 1000. The light emitting apparatus 1000 may be a display module or a display apparatus.

The light emitting apparatus 1000 may include a circuit board 1010 and a plurality of light emitting devices 200, 300, 400 disposed on one surface of the circuit board 1010. The light emitting apparatus 1000 may further include a controller controlling operation of the plurality of light emitting devices 200, 300, 400.

The circuit board 1010 may have the same or similar configuration to those shown in FIG. 7A to FIG. 9. The circuit board 1010 may be a substrate for mounting the light emitting devices 200, 300, 400, which will be coupled to a separate display substrate, or may be a display substrate, such as a panel.

The circuit board 1010 may further include circuitry for passive matrix driving or active matrix driving. Specifically, the circuit board 1010 may include interconnections and resistors therein and may further include passive and active elements of transistors and capacitors. The circuit board 1010 may also be formed on upper and lower surfaces thereof with pads that allow electrical connection to circuits disposed therein.

The light emitting devices 200, 300, 400 may have the same or similar configuration to those described with reference to FIG. 1 to FIG. 5, or may be formed in a different structure. That is, the light emitting devices 200, 300, 400 may be formed in a different size, shape, or dimension than those shown in FIG. 1 to FIG. 5 and the protrusions P may be omitted as an optional configuration.

For example, the light emitting devices 200, 300, 400 are light emitting diode chips, which are disposed on one surface of the circuit board 1010 and generate light, and may have various configurations.

The light emitting devices 200, 300, 400 may include semiconductor layers formed on the substrate 110.

The substrate 110 is a substrate on which the semiconductor layers will be disposed and may be selected from any substrates allowing a nitride semiconductor to be disposed thereon. For example, the substrate 110 may include a heterogeneous substrate, such as a sapphire substrate, a gallium arsenide substrate, a silicon substrate, a silicon carbide substrate, or a spinel substrate, and may also include a homogeneous substrate, such as a gallium nitride substrate, an aluminum nitride substrate, or others. The substrate 110 may be a growth substrate on which semiconductor layers are grown. Here, the protrusions P may not be formed on the substrate 110 and protrusions with a different size, shape, or pattern than the protrusions P described with reference to FIG. 1 to FIG. 5 may be formed thereon. Alternatively, the substrate 110 may be removed depending on the shape of the light emitting devices 200, 300, 400.

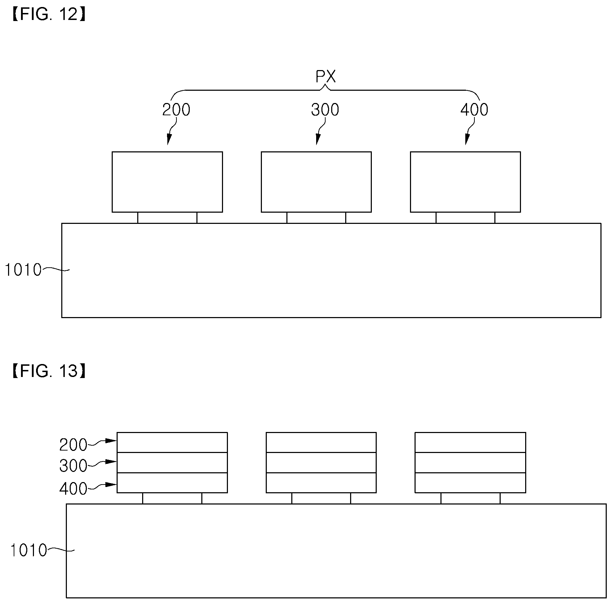

Referring to FIG. 10, the first to third light emitting devices 200, 300, 400 disposed in a first direction in a plane (Y-axis direction with respect to FIG. 10) may be arranged on the circuit board 1010 to form a single pixel PX. The first to third light emitting devices 200, 300, 400 may be arranged side by side in a transverse direction, as shown in FIG. 10 and FIG. 12. In this case, the three light emitting devices 200, 300, 400 may display three primary colors of RGB as the pixel PX. However, it should be understood that the embodiment is not limited thereto and each of the RGB light emitting devices 200, 300, 400 may be arranged out of alignment.

A plurality of pixels PX may be arranged in a grid pattern in the first direction (Y-axis direction) and a second direction (X-axis direction) perpendicular thereto in the plane.

In addition to the example where the first to third light emitting devices 200, 300, 400 of RGB are disposed horizontally in the first direction to form a single pixel PX, as shown in FIG. 10 and FIG. 12, the first to third light emitting devices 200, 300, 400 of RGB may be stacked vertically to form a single pixel PX, as shown in FIG. 13.

Each of the light emitting devices 200, 300, 400 may be a small light emitting device having a micro-scale size and may have a width of 1,000 micrometers or less.

Within the pixel PX, a distance M1 between adjacent pixels PX in the second direction (X-axis direction with reference to FIG. 1) perpendicular to the first direction (Y-axis direction with reference to FIG. 1) in which the first to third light emitting devices 200, 300, 400 are arranged may be greater than a width M2 of the pixel PX in the second direction.

A molding layer may be formed on the plurality of light emitting devices 200, 300, 400.

The molding layer may cover the plurality of light emitting devices 200, 300, 400 and may include various fillers, a light absorbing material, such as carbon black, a light reflection material, or others to improve light extraction efficiency. The molding layer may act as a kind of buffer layer and may cover not only the light emitting devices 200, 300, 400 but also the upper surface of the substrate 1010. The substrate 1010 may support the plurality of light emitting devices 200, 300, 400 and the molding layer.

The molding layer may have the same or similar configuration to the molding layer 900 described above.

The molding layer may further include a wavelength conversion material capable of converting the wavelength of light emitted from the plurality of light emitting diodes 120, 130, 140. For example, the wavelength conversion material may include a fluorescent material capable of emitting at least one of red light, blue light, and green light. The fluorescent material may be distributed within the molding layer.

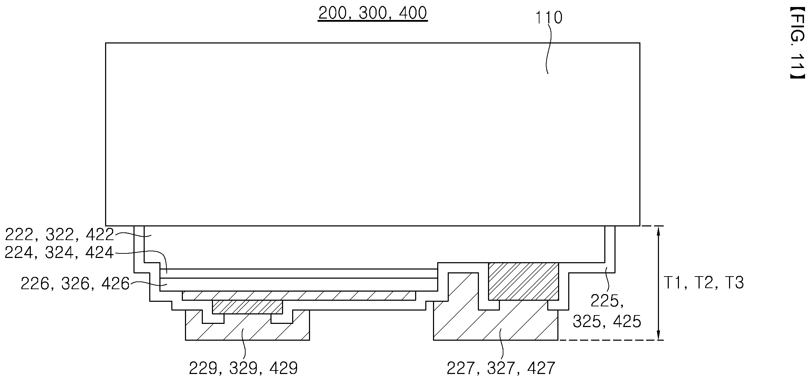

Referring to FIG. 11, the first to third light emitting devices 200, 300, 400 may include first conductivity type semiconductor layers 222, 322, 422, active layers 224, 324, 424 each having a multi-quantum well structure, and second conductivity type semiconductor layers 226, 326, 426, respectively.

Each of the first conductivity type semiconductor layers 222, 322, 422 may have the same or similar configuration to the first conductivity type semiconductor layer 122 described with reference to FIG. 1 to FIG. 5 and detailed description thereof will be omitted to avoid redundancy.

The active layers 224, 324, 424 are light emitting layers respectively formed on the first conductivity type semiconductor layer 222, 322, 422 and may have a multi-quantum-well structure (MQW). The active layers 224, 324, 424 may have the same or similar configuration to the active layer 124 described with reference to FIG. 1 to FIG. 5 and detailed description thereof will be omitted to avoid redundancy.

The second conductivity type semiconductor layers 226, 326, 426 may be semiconductor layers respectively formed on the active layers 224, 324, 424. The second conductivity type semiconductor layers 226, 326, 426 may have the same or similar configuration to the second conductivity type semiconductor layer 126 described with reference to FIG. 1 to FIG. 5 and detailed description thereof will be omitted to avoid redundancy.

The second conductivity type semiconductor layers 226, 326, 426 may include p-type semiconductor layers 226a, 326a, 426a and electron blocking layers 226b, 326b, 426b each having a high energy bandgap between the p-type semiconductor layers 226a, 326a, 426a and the active layers 224, 324, 424, respectively.

The electron blocking layers 226b, 326b, 426b are placed on the active layers 224, 324, 424, respectively, and can prevent electrons from overflowing from the active layers 224, 324, 424 to another layer above the active layers 224, 324, 424.

The electron blocking layers 226b, 326b, 426b may be formed on the uppermost barrier layers 224a, 324a, 424a of the active layers 224, 324, 424, respectively.

The electron blocking layers 226b, 326b, 426b may have a greater average energy bandgap than the uppermost barriers layer 224a, 324a, 424a, whereby migration of electrons to the second conductivity type semiconductor layers 226, 326, 426 can be blocked by energy barriers of the electron blocking layers 226b, 326b, 426b.

The first to third light emitting devices 200, 300, 400 may include insulation layers 225, 325, 425 covering the first conductivity type semiconductor layers 222, 322, 422 and the second conductivity type semiconductor layers 226, 326, 426, respectively, and each defining openings in which two electrode pads 227, 229; 327, 329; or 427, 429 are disposed. The two electrode pads 227, 229; 327, 329; or 427, 429 may be electrically connected to the first conductivity type semiconductor layer 222, 322 or 422 and the second conductivity type semiconductor layer 226, 326 or 426, respectively, through the openings in the insulation layer 225, 325 or 425. However, it should be understood that the structure of the light emitting devices 200, 300, 400 according to this embodiment is not limited thereto.

Referring to FIG. 22, each of the first to third light emitting devices 200, 300, 400 may have a V-pit formed in a growth process of each layer.

The structures of the light emitting devices 200, 300, 400 shown in FIG. 11 may be processed in various ways, whereby the light emitting devices 200, 300, 400 with various structures can be realized. It will be apparent that each of the light emitting devices 200, 300, 400 may be modified into various structures, such as a flip-chip type light emitting device, a vertical type light emitting device, a horizontal type light emitting device, and the like.

Light emitted from the first to third light emitting devices 200, 300, 400 may have the same or different peak wavelengths.

That is, when the first light emitting device 200 generates light having a first peak wavelength, the second light emitting device 300 generates light having a second peak wavelength, and the third light emitting device 400 generates light having a third peak wavelength, the first to third peak wavelengths may be the same or at least one of the first to third peak wavelengths may be different from the other peak wavelengths.

By way of example, the first light emitting device 200 may be a blue light emitting diode that emits blue light B and has a peak wavelength within the blue wavelength band, in which a difference between a peak wavelength and a dominant wavelength of the blue light emitting diode may be in the range of 2 nm to 15 nm. Specifically, the blue light emitting diode may have a peak wavelength of 430 nm to 475 nm and a dominant wavelength of 460 nm to 480 nm. The peak wavelength of the blue light emitting diode may be shorter than the dominant wavelength thereof.

The second light emitting device 300 may be a green light emitting diode that emits green light G and has a peak wavelength within the green wavelength band, in which a difference between the peak wavelength and a dominant wavelength of the green light emitting diode may be in the range of 5 nm to 20 nm. Specifically, the green light emitting diode may have a peak wavelength of 510 nm to 540 nm and a dominant wavelength of 525 nm and 545 nm. The peak wavelength of the green light emitting diode may be shorter than the dominant wavelength thereof.

The third light emitting device 400 may be a red light emitting diode that emits red light R and has a peak wavelength within the red wavelength band, in which a difference between the peak wavelength and a dominant wavelength of the red light emitting diode may be in the range of 5 nm to 30 nm. Specifically, the red light emitting diode may have a peak wavelength of 620 nm to 640 nm and a dominant wavelength of 600 nm to 630 nm. The peak wavelength of the red light emitting diode may be longer than the dominant wavelength thereof.

The deviations of the peak wavelengths and the dominant wavelengths of the light emitting devices 200, 300, 400 may have different deviation values. For example, the deviation of the peak wavelength and the dominant wavelength of the blue light emitting device 200 may be less than the deviation of the peak wavelength and the dominant wavelength of the green light emitting device 300. The deviation of the peak wavelength and the dominant wavelength of the green light emitting device 300 may be less than the deviation of the peak wavelength and the dominant wavelength of the red light emitting device 400. In this way, by managing the deviation of the peak wavelengths and the dominant wavelength of each of the blue light emitting device 200, the green light emitting device 300, and the red light emitting device 400, the light emitting apparatus can improve color purity and visual sensitivity of colors realizing images of the display apparatus.

On the other hand, the first peak wavelength and the second peak wavelength may be different from each other and the number of pairs of barrier layers 324a and well layers 324b constituting the active layer 324 of the second light emitting device 300 may be different from the number of pairs of barrier layers 224a and well layers 224b constituting the active layer 224 of the first light emitting device 200.

Stated differently, the number of barrier layers 324a and well layers 324b constituting the active layer 324 of the second light emitting device 300 may be different from the number of barrier layers 224a and well layers 224b constituting the active layer 224 of the first light emitting device 200. As a result, the active layers 224, 324 of the light emitting devices 200, 300 may have different average indexes of refraction to increase light extraction.

By way of example, the second light emitting device 300 may be configured to emit light having a longer peak wavelength than the first light emitting device 200, in which the second light emitting device 300 may be a green light emitting diode and the first light emitting device 200 may be a blue light emitting diode.

Here, the pair number of the active layer 324 of the second light emitting device 300 may be less than the pair number of the active layer 224 of the first light emitting device 200. The pair number of the active layer 224 of the first light emitting device 200 may be greater than 1 times and less than 3 times the pair number of the active layer 324 of the second light emitting device 300.

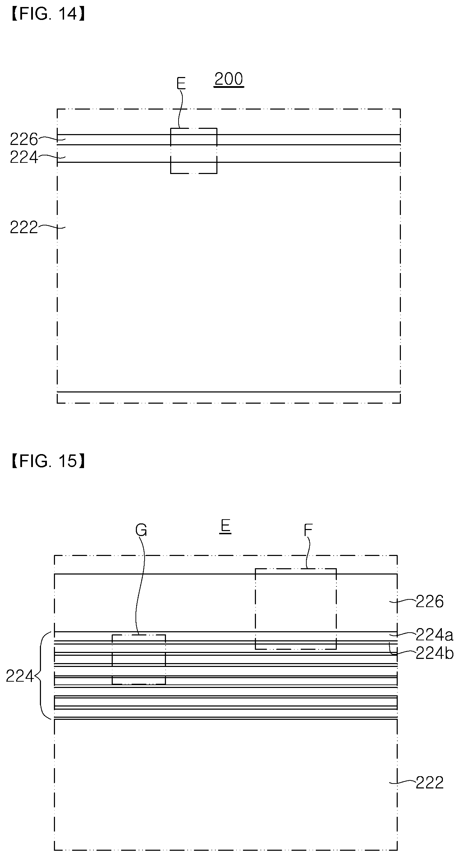

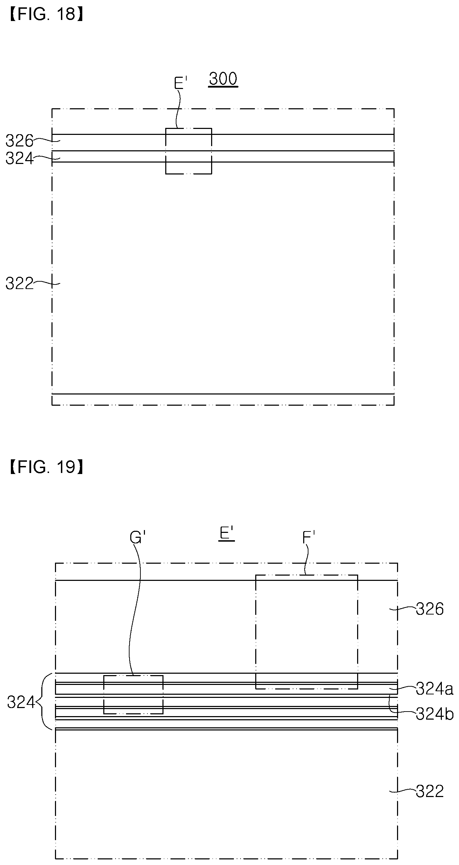

For example, as shown in FIG. 15, the pair number of the active layer 224 of the first light emitting device 200 may be eight and the pair number of the active layer 324 of the second light emitting device 300 may be less than eight (for example, referring to FIG. 19, five pairs).

Since the pair number of the active layer 224 of the first light emitting device 200 emitting blue light is greater than the pair number of the active layer 324 of the second light emitting device 300 emitting green light, this means that the number of barrier layers 224a or well layers 224b constituting the active layer 224 of the first light emitting device 200 emitting blue light is greater than the number of barrier layers 324a or well layers 324b constituting the active layer 324 of the second light emitting device 300 emitting green light.

The number of barrier layers 224a or well layers 224b of the active layer 224 of the first light emitting device 200 may be greater than 1 times and less than 3 times the number of barrier layers 324a or well layers 324b of the active layer 324 of the second light emitting device 300.

In addition, a thickness T52 of at least one barrier layer 324a constituting the active layer 324 of the second light emitting device 300 may be different from a thickness T51 of at least one barrier layer 224a constituting the active layer 224 of the first light emitting device 200. Accordingly, with respect to light emitted from the light emitting devices 200, 300, the barrier layers 224a, 324a of adjacent light emitting devices 200, 300 may act as distributed Bragg reflectors to increase light extraction.

The second light emitting device 300 may be configured to emit light having a longer peak wavelength than the first light emitting device 200, in which the thickness T52 of the at least one barrier layer 324a constituting the active layer 324 of the second light emitting device 300 may be greater than the thickness T51 of the at least one barrier layer 224a constituting the active layer 224 of the first light emitting device 200.

The thickness T51 of the at least one barrier layer 224a constituting the active layer 224 of the first light emitting device 200 may have a value in the range of 0.8 to 0.95 times the thickness T52 of the at least one barrier layer 324a constituting the active layer 324 of the second light emitting device 300.

Further, a thickness T62 of at least one well layer 324b constituting the active layer 324 of the second light emitting device 300 may be different from a thickness T61 of at least one well layer 224b constituting the active layer 224 of the first light emitting device 200. Thus, with respect to light emitted from the light emitting devices 200, 300, the well layers 224b, 324b of adjacent light emitting devices 200, 300 may act as distributed Bragg reflectors to increase light extraction.

The second light emitting device 300 may be configured to emit light having a longer peak wavelength than the first light emitting device 200, in which the thickness T62 of the at least one well layer 324b constituting the active layer 324 of the second light emitting device 300 may be greater than the thickness T61 of the at least one well layer 224b constituting the active layer 224 of the first light emitting device 200.

The thickness T61 of the at least one well layer 224b constituting the active layer 224 of the first light emitting device 200 may have a value in the range of 0.8 to 0.95 times the thickness T62 of the at least one well layer 324b constituting the active layer 324 of the second light emitting device 200.

Furthermore, the composition of Group **III** materials of the barrier layer 324a constituting the active layer 324 of the second light emitting device 300 may be different from the composition of Group III materials of the barrier layer 224a constituting the active layer 224 of the first light emitting device 200. Thus, it is possible to form the active layers 224, 324 to be suitable for extraction of light emitted from adjacent light emitting device 200, 300 while reducing influence on the active layers 224, 324 of the adjacent light emitting devices 200, 300.

Further, the aluminum content of the barrier layer 324a constituting the active layer 324 of the second light emitting device 300 may be different from the aluminum content of the barrier layer 224a constituting the active layer 224 of the first light emitting device 200.

The second light emitting device 300 may be configured to emit light having a longer peak wavelength than the first light emitting device 200, in which the aluminum content of the barrier layer 324a constituting the active layer 324 of the second light emitting device 300 may be less than the aluminum content of the barrier layer 224a constituting the active layer 224 of the first light emitting device 200. Accordingly, the average energy bandgap of the barrier layers 324a of the second light emitting device 300 may be less than the average energy bandgap of the barrier layers 224a of the first light emitting device 200. Here, the average energy bandgap refers to an average value of energy bandgaps of the respective barrier layers. Alternatively, the sum of the aluminum contents of the plurality of barrier layers 324a constituting the active layer 324 of the second light emitting device 300 may be less than the sum of the aluminum contents of the plurality of barrier layers 224a constituting the active layer 224 of the first light emitting device 200. Here, the sum of the aluminum contents may be derived by summing the aluminum contents of the respective barrier layers.

Further, the composition of Group III materials of the well layer 324b constituting the active layer 324 of the second light emitting device 300 may be different from the composition of Group III materials of the well layer 224b constituting the active layer 224 of the first light emitting device 200.

The indium content of the well layer 324b constituting the active layer 324 of the second light emitting device 300 may be greater than the indium content of the well layer 224b constituting the active layer 224 of the first light emitting device 200. Accordingly, the average energy bandgap of the well layers 324b of the second light emitting device 300 may be less than the average energy bandgap of the well layers 224b of the first light emitting device 200. Here, the average energy bandgap refers to an average value of energy bandgaps of the respective barrier layers. Alternatively, the sum of the indium contents of the plurality of well layers 324b constituting the active layer 324 of the second light emitting device 300 may be greater than the sum of the indium contents of the plurality of well layers 224b constituting the active layer 224 of the first light emitting device 200. Here, the sum of the indium contents may be derived by summing the indium contents of the respective well layers.

In addition, a thickness T42 of the electron blocking layer 326b of the second light emitting device 300 may be different from a thickness T41 of the electron blocking layer 226b of the first light emitting device 200. Thus, the thicknesses of the electron blocking layers 226b, 326b each having a large energy bandgap in the light emitting devices 200, 300 may be different for each of the light emitting devices 200, 300, thereby improving emission efficiency of light through refraction without absorption.

The second light emitting device 300 may be configured to emit light having a longer peak wavelength than the first light emitting device 200, in which the thickness T42 of the electron blocking layer 326b of the second light emitting device 300 may be greater than the thickness T41 of the electron blocking layer 226b of the first light emitting device 200. The thickness T41 of the electron blocking layer 226b of the first light emitting device 200 may have a value in the range of 3 to 4 times the thickness T42 of the electron blocking layer 326b of the second light emitting device 300.

In addition, the number of pairs of superlattice layers of the second light emitting device 300 may be different from the number of pairs of superlattice layers of the first light emitting device 200.

The second light emitting device 300 may be configured to emit light having a longer peak wavelength than the first light emitting device 200, in which the number of pairs of superlattice layers of the second light emitting device 300 may be greater than the number of pairs of superlattice layers of the first light emitting device 200.

Further, the V-pit formed in the second light emitting device 300 may have a different size than the V-pit formed in the first light emitting device 200.

The second light emitting device 300 may be configured to emit light having a longer peak wavelength than the first light emitting device 200, in which the V-pit V of the second light emitting device 300 may have a larger size than the V-pit V of the first light emitting device 200. Here, the size of the V-pit may refer to an upper width and a depth of the V-pit.

Further, the total thickness T2 of the second light emitting device 300 may be different from the total thickness T1 of the first light emitting device 200.

The second light emitting device 300 may be configured to emit light having a longer peak wavelength than the first light emitting device 200, in which the thickness T2 of the second light emitting device 300 may be greater than the thickness T1 of the first light emitting device 200. Thus, with different heights of the upper surfaces of the light emitting devices 200, 300, the light emitting apparatus can reduce reflection of external light incident on the light emitting devices 200, 300 by the surfaces of the light emitting devices 200, 300.

Hereinafter, the structure, composition, and bandgap of the third light emitting device 400 will be compared with those of other light emitting diodes in the case where the third light emitting device 400 emits light having a third peak wavelength that is different from the first peak wavelength and the second peak wavelength, particularly in the case where the third peak wavelength of the third light emitting device 400 is longer than the first peak wavelength and the second peak wavelength. Here, the third light emitting device 400 is a light emitting diode that emits light having a third peak wavelength different from the first peak wavelength and the second peak wavelength, and may be a light emitting diode that emits red light.

First, the third peak wavelength may be different from the first and second peak wavelengths and the number of pairs of the barrier layers 424a and the well layers 424b constituting the active layer 424 of the third light emitting device 400 may be different from the number of pairs of the barrier layers 224a, 324a and the well layers 224b, 324b constituting the active layers 224, 324 of the first and second light emitting devices 200, 300. Stated differently, the number of barrier layers 424a and well layers 424b constituting the active layer 424 of the third light emitting device 400 may be different from the number of barrier layers 224a, 324a and well layers 224b, 324b constituting the active layers 224, 324 of the first and second light emitting devices 200, 300.

The pair number of the active layer 424 of the third light emitting device 400 may be greater than the pair number of each of the active layers 224, 324 of the first and second light emitting devices 200, 300. The pair number of the active layer 424 of the third light emitting device 400 may be greater than or equal to 1.2 times and less than or equal to 5 times the pair number of the active layer 224 of the first light emitting device 200 and may be greater than or equal to 1.5 times and less than or equal to 5 times the pair number of the active layers 324 of the second light emitting device 300.

The pair number of the active layer 424 of the third light emitting device 400 may be greater than the pair number of the active layers 224, 324 of the first and second light emitting devices 200, 300, and the number of barrier layers 424a or well layers 424b constituting the active layer 424 of the third light emitting device 400 may be greater than that of the first and second light emitting devices 200, 300. The number of barrier layers 424a or well layers 424b of the active layer 424 of the third light emitting device 400 may be greater than or equal to 1.5 times and less than or equal to 5 times the number of barrier layers 224a or well layers 224b of the active layer 224 of the first light emitting device 200 and may be greater than or equal to 1.5 times and less than or equal to 5 times the number of barrier layers 324a or well layers 324b of the active layer 324 of the second light emitting device 300.

Further, the thickness of at least one barrier layer 424a constituting the active layer 424 of the third light emitting device 400 may be different from the thicknesses T51, T52 of the at least one barrier layer 224a, 324a constituting the active layers 224, 324 of the first and second light emitting devices 200, 300.

The third light emitting device 400 may be configured to emit light having a longer peak wavelength than the first light emitting device 200, in which the thickness of the at least one barrier layer 424a constituting the active layer 424 of the third light emitting device 400 may be greater than the thickness T51 of the at least one barrier layer 224a constituting the active layer 224 of the first light emitting device 200. The thickness of the barrier layer 424a constituting the active layer 424 of the third light emitting device 400 may have a value in the range of 1.5 to 5 times the thickness T51 of the barrier layer 224a constituting the active layer 224 of the first light emitting device 200.

The third light emitting device 400 may be configured to emit light having a longer peak wavelength than the second light emitting device 300, in which the thickness of the at least one barrier layer 424a constituting the active layer 424 of the third light emitting device 400 may be less than the thickness T52 of the barrier layer 324a constituting the active layer 324 of the second light emitting device 300. The thickness T52 of at least one barrier layer 324a constituting the active layer 324 of the second light emitting device 300 may have a value in the range of 1 to 2 times the thickness of the barrier layer 424a constituting the active layer 424 of the third light emitting device 400.

Further, the thickness of at least one well layer 424b constituting the active layer 424 of the third light emitting device 400 may be different from the thicknesses T61, T62 of the at least one well layer 224b, 324b constituting the active layers 224, 324 of the first and second light emitting devices 200, 300.

The third light emitting device 400 may be configured to emit light having a longer peak wavelength than the first light emitting device 200, in which the thickness of the at least one well layer 424b constituting the active layer 424 of the third light emitting device 400 may be greater than the thickness T61 of the at least one well layer 224b constituting the active layer 224 of the first light emitting device 200. The thickness of the at least one well layer 424b constituting the active layer 424 of the third light emitting device 400 may have a value in the range of 1.5 to 5 times the thickness T61 of the at least one well layer 224b constituting the active layer 224 of the first light emitting device 200.

The third light emitting device 400 may be configured to emit light having a longer peak wavelength than the second light emitting device 300, in which the thickness of the at least one well layer 424b constituting the active layer 424 of the third light emitting device 400 may be less than the thickness T62 of the at least one well layer 324b constituting the active layer 324 of the second light emitting device 300. The thickness T62 of the at least one well layer 324b constituting the active layer 324 of the second light emitting device 300 may have a value in the range of 1 to 2 times the thickness of the at least one well layer 424b constituting the active layer 424 of the third light emitting device 400.

Further, the composition of Group **III** materials of the barrier layer 424a constituting the active layer 424 of the third light emitting device 400 may be different from the compositions of Group **III** materials of the barrier layers 224a, 324a constituting the active layers 224, 324 of the first and second light emitting devices 200, 300.

Further, the aluminum content of the barrier layer 424a constituting the active layer 424 of the third light emitting device 400 may be different from the aluminum contents of the barrier layers 224a, 324a constituting the active layers 224, 324 of the first and second light emitting devices 200, 300.

The third light emitting device 400 may be configured to emit light having a longer peak wavelength than the first and second light emitting devices 200, 300, in which the aluminum content of the barrier layer 424a constituting the active layer 424 of the third light emitting device 400 may be greater than the aluminum contents of the barrier layers 224a, 324b constituting the active layers 224, 324 of the first and second light emitting devices 200, 300. Accordingly, the average energy bandgap of the barrier layers 424a of the third light emitting device 400 may be less than the average energy bandgaps of the barrier layers 224a, 324a of the first and second light emitting devices 200, 300. Here, the average energy bandgap refers to an average value of energy bandgaps of the respective barrier layers.

Further, the composition of Group III materials of the well layer 424b constituting the active layer 424 of the third light emitting device 400 may be different from the compositions of Group III materials of the well layers 224b, 324b constituting the active layers 224, 324 of the first and second light emitting devices 200, 300.

The third light emitting device 400 may be configured to emit light having a longer peak wavelength than the first and second light emitting devices 200, 300, in which the indium content of the well layer 424b constituting the active layer 424 of the third light emitting device 400 may be greater than the indium contents of the well layers 224b, 324b constituting the active layers 224, 324 of the first and second light emitting devices 200, 300.

Accordingly, the average energy bandgap of the well layers 424b of the third light emitting device 400 may be less than the average energy bandgaps of the well layers 224b, 324b of the first and second light emitting devices 200, 300. Here, the average energy bandgap refers to an average value of energy bandgaps of the respective barrier layers.

In addition, the type of Group V materials of the well layer 424b constituting the active layer 424 of the third light emitting device 400 may be different from the type of Group V materials of the well layers 224b, 324b constituting the active layers 224, 324 of the first and second light emitting devices 200, 300.

Further, the thickness of the electron blocking layer of the third light emitting device 400 may be different from the thicknesses T41, T42 of the electron blocking layers 226b, 326b of the first and second light emitting devices 200, 300.

The third light emitting device 400 may be configured to emit light having a longer peak wavelength than the first and second light emitting devices 200, 300, in which the thickness of the electron blocking layer of the third light emitting device 400 may be greater than the thicknesses T41, T42 of the electron blocking layers 226b, 326b of the first and second light emitting devices 200, 300.

Further, the number of pairs of superlattice layers of the third light emitting device 400 may be different from the number of pairs of superlattice layers of the first and second light emitting devices 200, 300.

The third light emitting device 400 may be configured to emit light having a longer peak wavelength than the first and second light emitting devices 200, 300, in which the number of pairs of superlattice layers of the third light emitting device 400 may be greater than the number of pairs of superlattice layers of the first and second light emitting devices 200, 300.

Further, the size of the V-pit formed in the third light emitting device 400 may be different from the sizes of the V-pits formed in the first and second light emitting devices 200, 300.

The third light emitting device 400 may be configured to emit light having a longer peak wavelength than the first and second light emitting devices 200, 300, in which the V-pit of the third light emitting device 400 may have a larger size than the V-pits of the first and second light emitting devices 200, 300.

Further, the overall thickness T3 of the third light emitting device 400 may be different from the overall thicknesses T1, T2 of the first and second light emitting devices 200, 300.

The third light emitting device 400 may be configured to emit light having a longer peak wavelength than the first and second light emitting devices 200, 300, in which the thickness T3 of the third light emitting device 400 may be greater than the thicknesses T1, T2 of the first and second light emitting devices 200, 300.

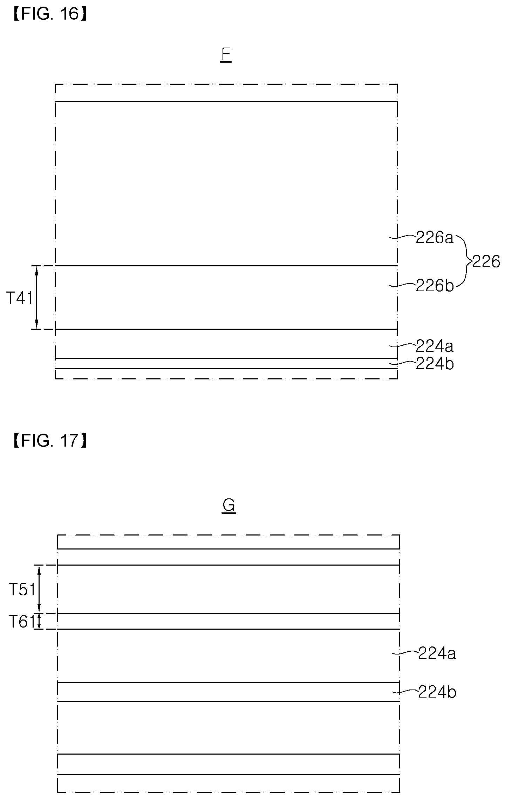

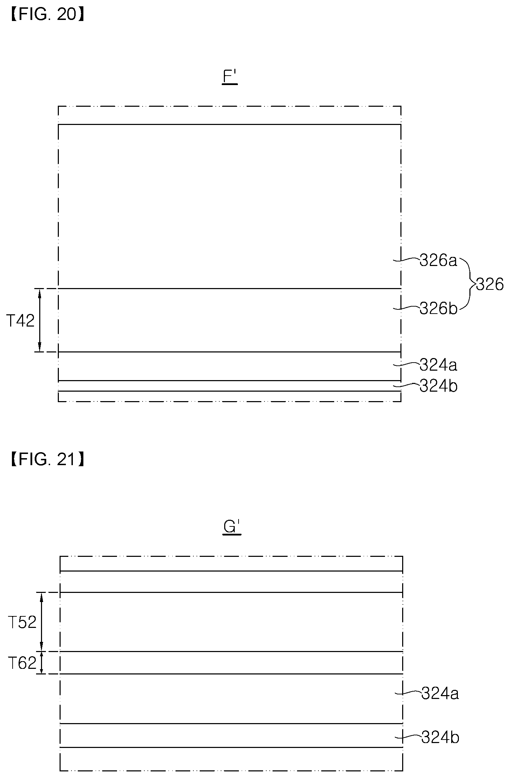

The light emitting devices 200, 300, 400 described with reference to FIG. 10 to FIG. 22 may also be applied to the light emitting apparatus 1000 shown in FIG. 6 to FIG. 8.

Although some exemplary embodiments have been described herein with reference to the accompanying drawings, it should be understood that various modifications and changes can be made by those skilled in the art without departing from the spirit and scope of the disclosed technology, as defined by the claims and equivalents thereto.

Therefore, the scope of the disclosed technology should not be limited to the detailed description, but limited by the accompanying claims and equivalents thereto.

[List of Reference Numerals]

110: Substrate
100, 200, 300, 400: Light emitting device

**Claims**

1. A light emitting device comprising: a substrate; a plurality of protrusions protruding from one surface of the substrate; and a light emitting structure disposed on the substrate,
   wherein, when a pitch between adjacent protrusions is denoted by D1 and a short-side length of the light emitting device in a plane is denoted by A, the light emitting device satisfies an equation: A = $\alpha \times$D1, where $\alpha$ is greater than or equal to 5.

2. The light emitting device according to claim 1, wherein, when a maximum width of the protrusions is denoted by D2, D2 has a value in a range of 1.5 $\mu$m to 2 $\mu$m.

3. The light emitting device according to claim 1, wherein, when a vertical height from one surface of the substrate to an apex of the protrusions is denoted by D3, D3 has a value in a range of 0.8 $\mu$m to 1.2 $\mu$m.

4. The light emitting device according to claim 1, wherein D1 has a value in a range of 1 to 1.5 times D2.

5. The light emitting device according to claim 1, wherein, when a vertical height from one surface of the substrate to an apex of the protrusions is denoted by D3, D1 has a value in a range of 1 to 3 times D3.

6. The light emitting device according to claim 2, wherein, when a vertical height from one surface of the substrate to an apex of the protrusions is denoted by D3, D2 has a value in a range of 1 to 3 times D3.

7. The light emitting device according to claim 1, wherein, when a maximum width of the protrusions is denoted by D2, the light emitting device satisfies an equation: A = $\beta \times$D2, where $\beta$ is greater than or equal to $\alpha$.

8. The light emitting device according to claim 1, wherein, when a vertical height from one surface of the substrate to an apex of the protrusions is denoted by D3, the light emitting device satisfies an equation: A = $\gamma$xD3, where $\gamma$ is greater than 2$\alpha$.

9. The light emitting device according to claim 1, wherein a height from an apex of the protrusions to an upper surface of the light emitting structure has a value in a range of 0.7 to 0.9 times a height from one surface of the substrate to the upper surface of the light emitting structure.

10. A light emitting apparatus comprising:

   a light emitting device including a substrate, a plurality of protrusions protruding from one surface of the substrate, and a light emitting structure disposed on the substrate; and
   a circuit board on which the light emitting device is mounted.

11. The light emitting apparatus according to claim 10, wherein the light emitting device further includes a light transmitting member covering the light emitting device, and
   wherein, when a maximum width of the protrusions is denoted by D2, a vertical height from one surface of the substrate to an apex of the protrusions is denoted by D3, a maximum width of the light transmitting member in a horizontal direction is denoted by S1, and a vertical height from an upper surface of the circuit board to an apex of the light transmitting member is denoted by S2, the light emitting apparatus satisfies a relation: $\dfrac{D2}{D3} < \dfrac{S1}{S2}$.

12. The light emitting apparatus according to claim 11, wherein $\dfrac{S1}{S2}$ is in a range of 1.5 to 3 times $\dfrac{D2}{D3}$.

13. The light emitting apparatus according to claim 10, further comprising:

   a molding layer covering the light emitting device,
   wherein, when a vertical height from one surface of the substrate to an apex of the protrusions is denoted by D3 and a vertical height from an upper surface of the light emitting device to an upper surface of the molding layer is denoted by L, L is greater than or equal to 50 times D3.

14. The light emitting apparatus according to claim 13, wherein, when a pitch between adjacent protrusions is denoted by D1 and a maximum width of the protrusions is denoted by D2, the light emitting apparatus satisfies a relation:

$$\dfrac{L}{2} > D1 + \text{D2} + \text{D3}.$$

15. A light emitting apparatus comprising: a substrate; a first light emitting device disposed on one surface of the substrate and configured to generate light having a first peak wavelength; a second light emitting device disposed on the one surface of the substrate configured to generate light having a second peak wavelength different from the first peak wavelength; and a third light emitting device disposed on the one surface of the substrate and configured to generate light having a third peak wavelength different from the first and second peak wavelengths,

wherein each of the first to third light emitting devices includes a first conductivity type semiconductor layer, an active layer having a multi-quantum well structure, and a second conductivity type semiconductor layer, and wherein a number of pairs of barrier layers and well layers constituting the active layer of the first light emitting device is different from a number of pairs of barrier layers and well layers constituting the active layer of the second light emitting device.

16. The light emitting apparatus according to claim 15, wherein the second peak wavelength is longer than the first peak wavelength and the number pairs of the active layer of the second light emitting diode is less than the number of pairs of the active layer of the first light emitting diode.

17. The light emitting apparatus according to claim 15, wherein the second peak wavelength is longer than the first peak wavelength and a thickness of a barrier layer of the barrier layers constituting the active layer of the second light emitting diode is greater than a thickness of a barrier layer of the barrier layers constituting the active layer of the first light emitting diode.

18. The light emitting apparatus according to claim 15, wherein the second peak wavelength is longer than the first peak wavelength and a thickness of a well layer of the well layers constituting the active layer of the second light emitting diode is greater than a thickness of a well layer of the well layers constituting the active layer of the first light emitting diode.

19. The light emitting apparatus according to claim 15, wherein the second peak wavelength is longer than the first peak wavelength and an aluminum content of a barrier layer of the barrier layers constituting the active layer of the second light emitting diode is less than an aluminum content of a barrier layer of the barrier layers constituting the active layer of the first light emitting diode.

20. The light emitting apparatus according to claim 15, wherein the second peak wavelength is longer than the first peak wavelength and each of the first to third light emitting devices is formed with a V-pit therein, the V-pit of the second light emitting device having a larger size than the V-pit of the first light emitting device.

【FIG. 1】

【FIG. 2】

【FIG. 3】

【FIG. 4】

【FIG. 5】

【FIG. 6】

【FIG. 7a】

【FIG. 7b】

【FIG. 8】

【FIG. 9】

【FIG. 10】

[FIG. 11]

200, 300, 400

110

222, 322, 422
224, 324, 424
226, 326, 426

225,
325, 425

T1, T2, T3

229, 329, 429

227, 327, 427

EP 4 753 413 A1

28

【FIG. 12】

【FIG. 13】

【FIG. 14】

200

E

226
224

222

【FIG. 15】

G     E     F

226

224a
224b

224

222

【FIG. 16】

F

226a
226
226b

T41

224a
224b

【FIG. 17】

G

T51
T61

224a

224b

【FIG. 18】

【FIG. 19】

【FIG. 20】

F'

326a
326
326b

T42

324a
324b

【FIG. 21】

G'

T52

T62

324a

324b

【FIG. 22】

200, 300, 400

226, 326, 426

224, 324, 424

222, 322, 422

## INTERNATIONAL SEARCH REPORT

| International application No. |
|---|
| **PCT/KR2024/010764** |

| **A.** | **CLASSIFICATION OF SUBJECT MATTER** |
|---|---|

**H01L 33/22**(2010.01)i; **H01L 33/58**(2010.01)i; **H01L 33/48**(2010.01)i; **H01L 33/52**(2010.01)i; **H01L 25/075**(2006.01)i; **H01L 33/06**(2010.01)i

According to International Patent Classification (IPC) or to both national classification and IPC

| **B.** | **FIELDS SEARCHED** |
|---|---|

Minimum documentation searched (classification system followed by classification symbols)

H01L 33/22(2010.01); H01L 21/027(2006.01); H01L 25/075(2006.01); H01L 27/15(2006.01); H01L 33/12(2010.01); H01L 33/36(2010.01); H01L 33/58(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 발광소자(light-emitting-element), 돌출부(protrusion), 활성층(active-layer), 페어 (pair)

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| Y | WO 2020-013563 A1 (SEOUL VIOSYS CO., LTD.) 16 January 2020 (2020-01-16)<br>See paragraphs [0082]-[0146]; claim 1; and figure 6. | 1-10,15-20 |
| A | | 11-14 |
| Y | KR 10-2065965 B1 (YOO, Jae Ik) 14 January 2020 (2020-01-14)<br>See claims 3-4; and figure 5. | 1-9 |
| Y | WO 2022-149863 A1 (SEOUL VIOSYS CO., LTD.) 14 July 2022 (2022-07-14)<br>See paragraphs [0087]-[0141]; claim 1; and figures 1-4. | 10,15-20 |
| A | KR 10-2015-0146162 A (LG INNOTEK CO., LTD.) 31 December 2015 (2015-12-31)<br>See entire document. | 1-20 |
| A | KR 10-2015-0052205 A (ASAHI KASEI E-MATERIALS CORPORATION) 13 May 2015 (2015-05-13)<br>See entire document. | 1-20 |

☐ Further documents are listed in the continuation of Box C.   ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **28 October 2024** | **28 October 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/010764**

| Patent document cited in search report | | | Publication date (day/month/year) | Patent family member(s) | | | Publication date (day/month/year) |
|---|---|---|---|---|---|---|---|
| WO | 2020-013563 | A1 | 16 January 2020 | CN | 111801806 | A | 20 October 2020 |
| | | | | CN | 111801806 | B | 09 April 2024 |
| | | | | CN | 113555477 | A | 26 October 2021 |
| | | | | CN | 113555478 | A | 26 October 2021 |
| | | | | CN | 210489638 | U | 08 May 2020 |
| | | | | EP | 3748701 | A1 | 09 December 2020 |
| | | | | EP | 3748701 | A4 | 02 March 2022 |
| | | | | JP | 2021-530856 | A | 11 November 2021 |
| | | | | JP | 2024-050867 | A | 10 April 2024 |
| | | | | JP | 7436371 | B2 | 21 February 2024 |
| | | | | KR | 10-2020-0005962 | A | 17 January 2020 |
| | | | | KR | 10-2020-0039956 | A | 17 April 2020 |
| | | | | KR | 10-2020-0042316 | A | 23 April 2020 |
| | | | | KR | 10-2554230 | B1 | 12 July 2023 |
| | | | | KR | 10-2673668 | B1 | 12 June 2024 |
| | | | | US | 11658264 | B2 | 23 May 2023 |
| | | | | US | 2021-0074883 | A1 | 11 March 2021 |
| | | | | US | 2023-0378394 | A1 | 23 November 2023 |
| KR | 10-2065965 | B1 | 14 January 2020 | None | | | |
| WO | 2022-149863 | A1 | 14 July 2022 | EP | 4254497 | A1 | 04 October 2023 |
| | | | | US | 2022-0216188 | A1 | 07 July 2022 |
| | | | | US | 2023-0093367 | A1 | 23 March 2023 |
| | | | | WO | 2023-101409 | A1 | 08 June 2023 |
| KR | 10-2015-0146162 | A | 31 December 2015 | KR | 10-2200027 | B1 | 11 January 2021 |
| KR | 10-2015-0052205 | A | 13 May 2015 | BR | 112015008057 | A2 | 04 July 2017 |
| | | | | CN | 104781941 | A | 15 July 2015 |
| | | | | EP | 2908353 | A1 | 19 August 2015 |
| | | | | EP | 2908353 | A4 | 28 October 2015 |
| | | | | EP | 3043392 | A1 | 13 July 2016 |
| | | | | JP | 2015-092576 | A | 14 May 2015 |
| | | | | JP | 5719090 | B2 | 13 May 2015 |
| | | | | RU | 2015117522 | A | 10 December 2016 |
| | | | | TW | 201421736 | A | 01 June 2014 |
| | | | | TW | 201603314 | A | 16 January 2016 |
| | | | | TW | I514618 | B | 21 December 2015 |
| | | | | US | 2016-0056352 | A1 | 25 February 2016 |
| | | | | WO | 2014-057808 | A1 | 17 April 2014 |

Form PCT/ISA/210 (patent family annex) (July 2022)